(19) **Europäisches Patentamt / European Patent Office / Office européen des brevets**

(11) **EP 4 748 968 A1**

(12) **EUROPEAN PATENT APPLICATION**
published in accordance with Art. 153(4) EPC

(43) Date of publication:
27.05.2026 Bulletin 2026/22

(21) Application number: 24843517.4

(22) Date of filing: 18.07.2024

(51) International Patent Classification (IPC):
$C23C\ 16/455^{(2006.01)}$ $\quad$ $C23C\ 16/44^{(2006.01)}$
$C23C\ 16/34^{(2006.01)}$ $\quad$ $C23C\ 16/40^{(2006.01)}$
$H01L\ 21/02^{(2006.01)}$

(52) Cooperative Patent Classification (CPC):
C23C 16/34; C23C 16/40; C23C 16/44;
C23C 16/455; H10P 95/00

(86) International application number:
PCT/KR2024/010330

(87) International publication number:
WO 2025/018802 (23.01.2025 Gazette 2025/04)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 18.07.2023 KR 20230093074

(71) Applicant: Hansol Chemical Co., Ltd
Seoul 06169 (KR)

(72) Inventors:
• HAN, Jeong-Woo
Jeonju-si, Jeonbuk-do 54828 (KR)
• AN, Jae-Seok
Wanju-gun, Jeonbuk-do 55316 (KR)

(74) Representative: Ipsilon
Le Contemporain
50 Chemin de la Bruyère
69574 Dardilly Cedex (FR)

(54) **METHOD FOR FORMING THIN FILM USING TWO TYPES OF SILICON PRECURSOR COMPOUNDS**

(57) The present application relates to a method for manufacturing a silicon thin film using two types of silicon precursor compounds and, specifically, to a method for manufacturing a silicon thin film, which has excellent thin film characteristics and can control morphology according to the precursor, through atomic layer deposition (ALD) even at low temperatures.

Figure 1

EP 4 748 968 A1

## Description

## Technical Field

The present application relates to a method of forming a silicon thin film having excellent properties through atomic layer deposition (ALD) using two types of silicon precursors even at low temperatures.

## Background Art

Thin films containing silicon can recently be manufactured in various types through diverse processes in the semiconductor field. In particular, silicon oxide films and silicon nitride films are usable as insulating films, diffusion barrier films, hardmasks, etch stop layers, seed layers, spacers, trench isolation, intermetallic dielectric materials, or protective film layers in device fabrication due to having excellent barrier properties and oxidation resistance. Recently, polycrystalline silicon thin films have been used in thin film transistors (TFTs), solar cells, and the like, and the application fields thereof are gradually diversifying.

Representative technologies known for manufacturing thin films containing silicon include ALD, in which a gaseous precursor is adsorbed physically or chemically onto the surface of a substrate, and then a film is formed by introducing a reaction gas in sequence, and metal-organic chemical vapor deposition (MOCVD), in which a mixed gaseous organometallic precursor and a reaction gas react to form a film on the surface of a substrate or react directly on the surface to form a film. Various thin film manufacturing technologies using the aforementioned technologies, including low-pressure chemical vapor deposition (LPCVD) or plasma-enhanced chemical vapor deposition (PECVD) and plasma-enhanced atomic layer deposition (PEALD), both enabling low-temperature deposition, and the like, are applied to manufacturing processes of devices such as next-generation semiconductors, and are used to form ultra-fine patterns and deposit thin films that are uniform in thickness at the nanoscale and have excellent properties.

In particular, thin films used in semiconductor devices must be controllable at the atomic level and have excellent step coverage. A technology applicable to this case is ALD. As the development of highly isotopic thin film deposition methods enabling nanoscale thickness control becomes a significantly important factor, ALD is gaining attention as the most promising deposition technique for a wide range of applications to nanoscale devices. There are expectations that ALD will be able to solve problems, such as high leakage current, caused by device miniaturization. Furthermore, an additional advantage of ALD is that thin films involving atomic-level compositional variations, other than single high-dielectric materials, can be deposited. The principle of ALD is that a single atomic layer is deposited by supplying each reactant onto a wafer, with the reactants separated by an inert gas (such as Ar or $N_2$). In this case, the deposition cycle is repeatedly performed to achieve the desired thickness. A thin film is formed through a reaction where one reactant is first chemically adsorbed onto a substrate onto which the thin film is to be deposited, and then a second or third gas is introduced and chemically absorbed again onto the substrate. Either a simple element or a compound is used as the reactant, and such a reactant is required to be highly volatile, stable, and highly reactive.

However, conventional ALD precursors require high-temperature processes at 600°C or higher when used, during which reactants decompose, causing defects and resulting in problems with deterioration in the physical and electrical properties of thin films, such as step coverage and etching characteristics.

Hence, a process that enables the low-temperature behavior of the deposition process, adhesion of the thin film, excellent step coverage, and thickness control at the atomic layer level is also required.

Ultimately, there is a need to develop a method of manufacturing a thin film in which an ALD process is possible even at low temperatures, and the thin film has excellent step coverage and exhibits excellent properties.

[Documents of related art]

[Patent Documents]

(Patent Document 1) Korean Patent Application Publication No. 2021-0024673
(Patent Document 2) Korean Patent Application Publication No. 2015-0102725

## Disclosure

## Technical Problem

The present application aims to provide a method enabling a thin film to be efficiently manufactured using two types of silicon precursors even at low temperatures, and a thin film having excellent properties manufactured thereby.

In particular, in conventional silicon thin film deposition, silicon thin films containing defects have been formed due to LPCVD. As a result, during high-temperature crystallization, polycrystalline silicon (poly-Si) thin films having a small grain boundary size have been formed.

Hence, the present application aims to provide a method of manufacturing a thin film, in which two types of silicon precursors are applied to ALD utilizing thermal energy instead of existing plasma, thereby securing the low-temperature ALD behavior even at temperatures of 500°C or lower and enabling conformal deposition even on patterns having a high aspect ratio.

However, the problems to be solved by the present application are not limited to the aforementioned description, and other problems not mentioned can be clearly understood by those skilled in the art from the following description.

**Technical Solution**

In one aspect of the present application, a thin film manufacturing method of depositing a thin film by repeatedly performing a cycle including the following steps of performing a first injection by injecting a first precursor compound into a chamber, and

performing a second injection by injecting a second precursor compound into the chamber,
wherein the first precursor compound is represented by Chemical Formula 1 or 2 below, and
the second precursor compound is represented by Chemical Formula 1 or 2 below,
may be provided.

(However, when the first precursor compound is a compound represented by Chemical Formula 1 below, the second precursor compound is a compound represented by Chemical Formula 2 below, and

when the first precursor compound is a compound represented by Chemical Formula 2 below, the second precursor compound is a compound represented by Chemical Formula 1 below.)

[Chemical Formula 1]       $Si_x(R_1)_yH_{(2x+2-y)}$

[Chemical Formula 2]       $Si(NR_2R_3)_zH_{(4-z)}$

In Chemical Formulas 1 and 2,

$R_1$ is any one selected from the group consisting of fluorine (F), chlorine (Cl), bromine (Br), and iodine (I),
$R_2$ and $R_3$ are each independently any one selected from the group consisting of straight-chain or branched-chain hydrocarbons having 1 to 4 carbon atoms,
$x$ is an integer in a range of 1 to 3,
$y$ is an integer in a range of 1 to 7, and
$z$ is an integer in a range of 1 to 3.

**Advantageous Effects**

A thin film manufacturing method of the present application can efficiently manufacture a silicon thin film having excellent properties.

Specifically, in the present application, a low-temperature ALD process is possible even at temperatures of 500°C or lower by introducing two types of silicon precursor compounds. In this case, these precursor compounds serve as a source and a reactant, and a thin film that is amorphous or nanocrystalline, depending on the types of precursor compounds, can be deposited.

In particular, by depositing an amorphous silicon thin film, a polycrystalline silicon thin film having a large grain boundary size can be manufactured during crystallization.

In other words, the thin film manufacturing method of the present application enables uniform deposition of a thin film having excellent properties even at low temperatures using two types of silicon precursor compounds. This allows the thin film obtained as above to secure excellent physical properties, thickness, and step coverage, and enables control of the morphology and crystallinity of the deposited thin film.

Furthermore, the thin film having excellent properties, manufactured by the thin film manufacturing method of the present disclosure, can be used in dielectrics, displays, next-generation memories, non-memory semiconductors, and the like of various electronic devices.

**Description of Drawings**

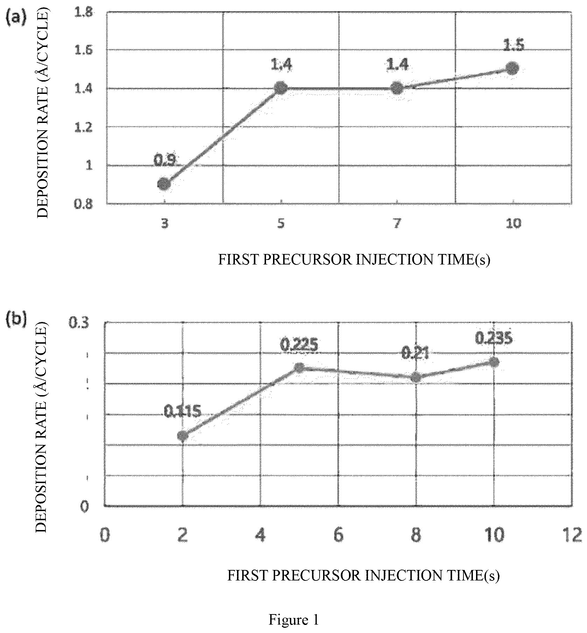

FIG. 1(a) is a graph showing changes in thin film deposition rate according to the injection time of a first precursor compound (diiodosilane, DIS) in Preparation Example 1 of the present application, and FIG. 1(b) is a graph showing changes in thin film deposition rate according to the injection time of a first precursor compound (tetrachlorodisilane, TCDS) in Preparation Example 2 of the present application.

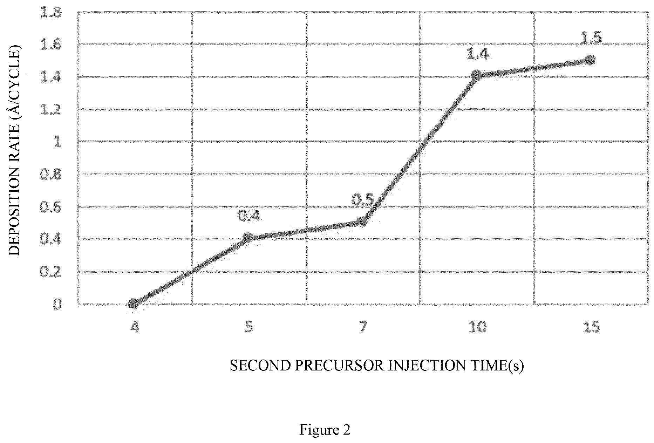

FIG. 2 is a graph showing changes in thin film deposition rate according to the injection time of a second precursor compound (diisopropylaminosilane, DIPAS) in Preparation Example 1 of the present application.

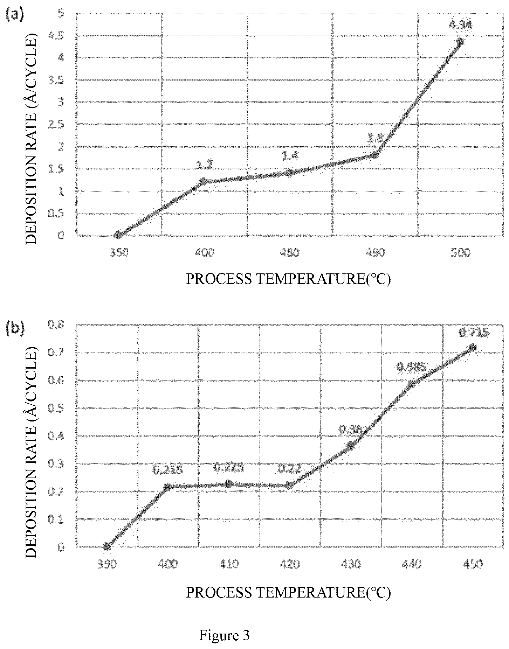

FIG. 3(a) is a graph showing changes in thin film deposition rate according to process temperatures in Preparation Example 1 of the present application, and FIG. 3(b) is a graph showing changes in thin film deposition rate according to process temperatures in Preparation Example 2 of the present application.

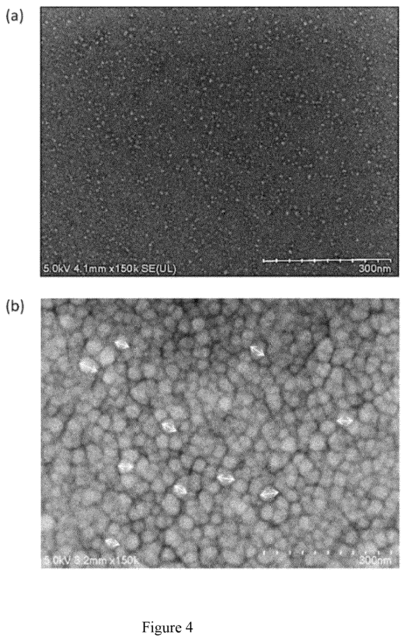

FIG. 4(a) shows a scanning electron microscope (SEM) image obtained by measuring the grain size of a thin film manufactured according to Preparation Example 1 of the present application at a process temperature of 400°C, and FIG. 4(b) shows an SEM image obtained by measuring the grain size of a thin film manufactured according to Preparation Example 1 of the present application at a process temperature of 480°C.

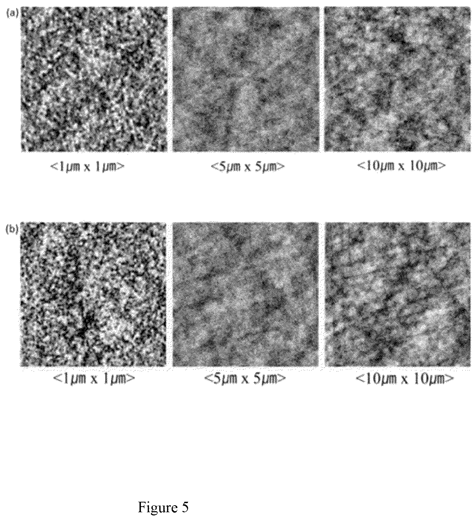

FIG. 5(a) shows atomic force microscope (AFM) images obtained by analyzing the morphological characteristics of a thin film manufactured according to Preparation Example 2 of the present application at a process temperature of 410°C, and FIG. 5(b) shows AFM images obtained by analyzing the morphological characteristics of a thin film manufactured according to Preparation Example 2 of the present application at a process temperature of 450°C.

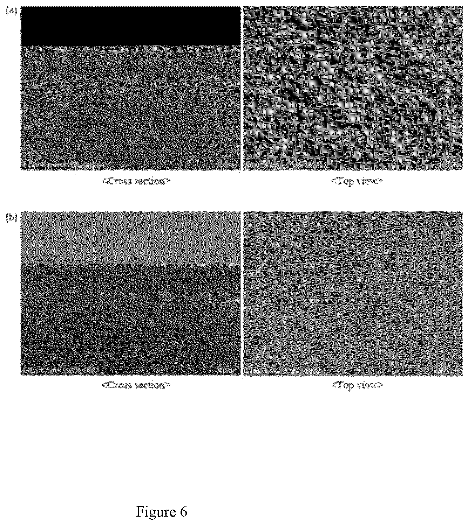

FIG. 6(a) shows SEM images obtained by measuring the roughness of a thin film manufactured according to Preparation Example 2 of the present application at a process temperature of 410°C, and FIG. 6(b) shows SEM images obtained by measuring the roughness of a thin film manufactured according to Preparation Example 3 of the present application at a process temperature of 410°C.

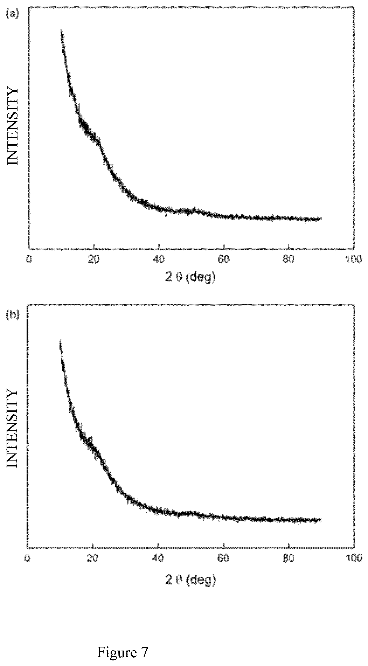

FIG. 7(a) is a graph showing X-ray diffraction (XRD) measurement for the morphological characteristics of a thin film manufactured according to Preparation Example 2 of the present application at a process temperature of 410°C, and FIG. 7(b) is a graph showing XRD measurement for the morphological characteristics of a thin film manufactured according to Preparation Example 2 of the present application at a process temperature of 410°C.

**Best Mode**

Hereinafter, the action and effect of the present disclosure will be described in more detail through specific embodiments of the present disclosure. However, such embodiments are provided only for illustrative purposes, and the scope of the present disclosure is not limited thereto.

Before discussing the details, it should be noted that all terms or words used herein and used in the appended claims are not construed as being limited to general and dictionary meanings but will be interpreted based on the meanings and concepts corresponding to the technical ideas of the present application, following the principle that any inventor is allowed to define the concepts of terms as appropriate to describe the disclosure thereof in the best mode.

Therefore, the embodiments described herein are configured merely as one of the most preferable examples of the present application and do not exhaustively represent the technical idea of the present disclosure. Accordingly, it should be appreciated that there may be various equivalents and modifications that can replace these embodiments as of the filing date of the present application.

As used herein, the singular expressions are intended to include the plural forms unless the context explicitly indicates otherwise. It will be further understood that the terms "comprise", "include", "have", and the like when used herein, are intended to specify the presence of stated features, integers, steps, constituent elements, or combinations thereof but do not preclude the possibility of the presence or addition of one or more other features, integers, steps, constituent elements, or combinations thereof.

As used herein, the expression "a to b" to represent a numerical range is defined as $\geq$ a and $\leq$ b.

A thin film manufacturing method according to one aspect of the present application enables a thin film deposition by repeatedly performing a cycle including the following steps of performing a first injection by injecting a first precursor compound into a chamber, and

performing a second injection by injecting a second precursor compound into the chamber.

In this case, the first precursor compound may be represented by Chemical Formula 1 or 2 below, and the second precursor compound may be represented by Chemical Formula 1 or 2 below.

(However, when the first precursor compound is a compound represented by Chemical Formula 1 below, the second precursor compound may be a compound represented by Chemical Formula 2 below, and

when the first precursor compound is a compound represented by Chemical Formula 2 below, the second precursor compound may be a compound represented by Chemical Formula 1 below.)

[Chemical Formula 1]     $Si_x(R_1)_yH_{(2x+2-y)}$

[Chemical Formula 2]     $Si(NR_2R_3)_zH_{(4-z)}$

In Chemical Formulas 1 and 2,

$R_1$ is any one selected from the group consisting of fluorine (F), chlorine (Cl), bromine (Br), and iodine (I),
$R_2$ and $R_3$ are each independently any one selected from the group consisting of straight-chain or branched-chain hydrocarbons having 1 to 4 carbon atoms,
x is an integer in a range of 1 to 3,
y is an integer in a range of 1 to 7, and
z is an integer in a range of 1 to 3.

For example, the precursor compound, which may be represented by Chemical Formula 1 or 2, may be injected in different orders.

In other words, when the first precursor compound is a compound represented by Chemical Formula 1, the second precursor compound is a compound represented by Chemical Formula 2. Conversely, when the first precursor compound is a compound represented by Chemical Formula 2, the second precursor compound is a compound represented by Chemical Formula 1.

For example, when the first precursor compound is DIS, the second precursor compound may be DIPAS, and when the first precursor compound is DIPAS, the second precursor compound may be DIS.

Additionally, when the first precursor compound is TCDS, the second precursor compound may be DIPAS, and when the first precursor compound is DIPAS, the second precursor compound may be TCDS.

For example, $R_1$ may be any one selected from the group consisting of fluorine (F), chlorine (Cl), bromine (Br), and iodine (I), and is preferably chlorine (Cl) or iodine (I).

For example, $R_2$ and $R_3$ may each independently be a straight-chain or branched-chain hydrocarbon having 1 to 2 carbon atoms, 1 to 3 carbon atoms, 1 to 4 carbon atoms, 2 to 3 carbon atoms, 2 to 4 carbon atoms, and 3 to 4 carbon atoms.

For example, x in Chemical Formula 1 may be 1, 2, or 3.

For example, y in Chemical Formula 1 may be in the range of 1 to 3 when x is 1, in the range of 1 to 5 when x is 2, and in the range of 1 to 7 when x is 3.

For example, z in Chemical Formula 2 may be 1, 2, or 3.

In one embodiment, $R_1$ in Chemical Formula 1 may be chlorine (Cl) or iodine (I),

x may be 1 or 2, and
y may be 2 or 4.

In one embodiment, $R_2$ and $R_3$ in Chemical Formula 2 are each independently any one selected from the group consisting of a methyl group, an ethyl group, an n-propyl group, an isopropyl group, an n-butyl group, an isobutyl group, a sec-butyl group, and a tert-butyl group, and
z may be 1 or 2.

In one embodiment, between the first injection step and the second injection step, a step of performing a first purge by injecting a first purge gas into the chamber, and
a step of performing a second purge by injecting a second purge gas into the chamber, after the second purge step, may be further included.

The thin film manufacturing method may be ALD or chemical vapor deposition (CVD), and is preferably ALD, but is not limited thereto.

In ALD, reactants are required to be highly volatile, stable, and highly reactive. ALD allows a sub-monolayer thin film to grow by a surface reaction during one deposition cycle in a manner in which each reaction raw material is supplied separately. In addition, the ligand of the reaction raw material, adsorbed onto the substrate, may be removed through a chemical reaction with another reaction raw material supplied later. When heating the precursor compound, the reactant, for ALD, the liquid state is much more advantageous than the solid state in terms of the reaction rate and process.

In one embodiment, the first and second purge gases may be inert gases such as argon (Ar), nitrogen (N2), or helium (He).

In one embodiment of the present application, in the absence of the second precursor compound, the low-temperature ALD behavior at process temperatures of 500°C or lower may not be secured smoothly, and the morphological characteristics of the deposited thin film may deteriorate.

Additionally, in one embodiment of the present application, the first precursor compound, which is a compound containing a silicon (Si) atom, may be a colorless liquid at room temperature.

In one embodiment, the compound that can be represented by Chemical Formula 1 may include fluorosilane, chlorosilane, bromosilane, iodosilane, difluorosilane, dichlorosilane, dibromosilane, DIS, trifluorosilane, trichlorosilane, tribromosilane, triiodosilane, tetrafluorosilane, tetrachlorosilane, tetrabromosilane, tetraiodosilane, fluorodisilane, chlorodisilane, bromodisilane, iododisilane, difluorodisilane, dichlorodisilane, dibromodisilane, diiododisilane, trifluorodisilane, trichlorodisilane, tribromodisilane, triiododisilane, tetrafluorodisilane, TCDS, tetrabromodisilane, and tetraiododisilane.

For example, the precursor compound that can be represented by Chemical Formula 1 may be any one selected from the group consisting of DIS and TCDS, but is not limited thereto.

In one embodiment, the compound that can be represented by Chemical Formula 2 may be any one of dimethylaminosilane, diethylaminosilane, DIPAS, dibutylaminosilane, diisobutylaminosilane, di-sec-butylaminosilane, dimethylethylsilane diamine, di-tert-butylaminosilane, dimethylpropylsilane diamine, and bis(diethylamino)silane (BDEAS).

For example, the compound that can be represented by Chemical Formula 2 may be any one selected from the group consisting of DIPAS and BDEAS, but is not limited thereto.

In one embodiment, a process temperature in the manufacturing method may be 350°C or higher and 500°C or lower.

For example, the process temperature may be 350°C or higher and 500°C or lower, 360°C or higher and 500°C or lower, 370°C or higher and 500°C or lower, 380°C or higher and 500°C or lower, 390°C or higher and 500°C or lower, 400°C or higher and 500°C or lower, 370°C or higher and 490°C or lower, 390°C or higher and 485°C or lower, 395°C or higher and 480°C or lower, 400°C or higher and 475°C or lower, 360°C or higher and 480°C or lower, 370°C or higher and 460°C or lower, 380°C or higher and 440°C or lower, 390°C or higher and 430°C or lower, 400°C or higher and 420°C or lower, 350°C or higher and 490°C or lower, 350°C or higher and 480°C or lower, 350°C or higher and 470°C or lower, 350°C or higher and 460°C or lower, 350°C or higher and 450°C or lower, 350°C or higher and 440°C or lower, 350°C or higher and 430°C or lower, 350°C or higher and 420°C or more, 350°C or higher and 410°C or lower, 350°C or higher and 400°C or lower, 360°C or higher and 450°C or lower, 370°C or higher and 450°C or lower, 380°C or higher and 450°C or lower, 390°C or higher and 450°C or lower, 400°C or higher and 450°C or lower, 410°C or higher and 450°C or lower, 420°C or higher and 450°C or lower, 430°C or higher and 450°C or lower, or 440°C or higher and 450°C or lower.

In one embodiment, according to the manufacturing method of the present application, in which first and second precursors of the present application are sequentially injected, an ALD window with the deposition rate being constant, regardless of the process temperature, can be observed at a temperature of 350°C or higher and 500°C or lower.

Specifically, when the first precursor compound is DIS, the process temperature may be 350°C or higher and 500°C or lower, which is preferably 400°C or higher and 500°C or lower, and more preferably 400°C or higher and 450°C or lower.

In addition, when the first precursor compound is TCDS, the process temperature may be 390°C or higher and 450°C or lower, which is preferably 400°C or higher and 450°C or lower, and more preferably 400°C or higher and 420°C or lower.

In the meantime, when the thin film, according to the present application, is manufactured at low temperatures below 350°C, deposition may fail to occur smoothly. This is because the reaction rate is insufficient, which may further slow down the deposition rate. In addition, the second precursor compound may fail to diffuse sufficiently, which may cause problems with defects or uniformity in the materials and the thin film and, therefore, make the substrate or the thin film unstable.

In addition, when the thin film, according to the present application, is manufactured at high temperatures exceeding 500°C, deposition may fail to occur smoothly. This may not only cause the reaction rate to become extremely fast, leading to the generation of impurities, but also cause the precursor or reaction gas to decompose, making thin film formation challenging.

In one embodiment, when the first precursor compound is DIS and the second precursor compound is DIPAS, the deposition rate (growth rate per cycle, GPC) of the thin film according to the manufacturing method may be in the range of 0.5 to 2.0 Å/cycle at a process temperature in the range of 400°C to 500°C.

For example, when the first precursor compound is DIS, the deposition rate of the thin film according to the manufacturing method may be in the range of 0.5 to 2.0 Å/cycle, in the range of 0.6 to 2.0 Å/cycle, in the range of 0.7 to 2.0 Å/cycle, in the range of 0.8 to 2.0 Å/cycle, in the range of 0.9 to 2.0 Å/cycle, in the range of 1.0 to 2.0 Å/cycle, in the range of 1.1 to 2.0 Å/cycle, in the range of 1.2 to 2.0 Å/cycle, in the range of 1.2 to 1.9 Å/cycle, in the range of 1.2 to 1.8 Å/cycle, in the range of 1.2 to 1.7 Å/cycle, in the range of 1.2 to 1.6 Å/cycle, in the range of 1.2 to 1.5 Å/cycle, or in the range of 1.2 to 1.4 Å/cycle at a process temperature in the range of 400°C to 500°C.

In one embodiment, when the first precursor compound is TCDS and the second precursor compound is DIPAS, the deposition rate of the thin film according to the manufacturing method may be in the range of 0.1 to 0.3 Å/cycle at a process temperature in the range of 400°C to 450°C.

For example, when the first precursor compound is TCDS, the deposition rate of the thin film according to the manufacturing method may be in the range of 0.1 to 0.3 Å/cycle, in the range of 0.12 to 0.28 Å/cycle, in the range of 0.14 to 0.26 Å/cycle, in the range of 0.16 to 0.24 Å/cycle, in the range of 0.18 to 0.24 Å/cycle, in the range of 0.19 to 0.24 Å/cycle, in the range of 0.20 to 0.24 Å/cycle, in the range of 0.215 to 0.24 Å/cycle, in the range of 0.18 to 0.22 Å/cycle, in the range of 0.19 to 0.22 Å/cycle, in the range of 0.20 to 0.22 Å/cycle, or in the range of 0.215 to 0.22 Å/cycle at a process temperature in the range of 400°C to 450°C.

In one embodiment, a canister for the first precursor compound may have a temperature of 0°C or higher and 50°C or lower.

For example, the temperature of the canister for the first precursor compound may be 0°C or higher and 50°C or lower, 5°C or higher and 45°C or lower, 10°C or higher and 40°C or lower, 15°C or higher and 35°C or lower, 20°C or higher and 25°C or lower, 20°C or higher and 30°C or lower, 25°C or higher and 30°C or lower, 5°C or higher and 30°C or lower, 10°C or higher and 30°C or lower, or 15°C or higher and 30°C or lower.

Additionally, a canister for the second precursor compound may have a temperature of 10°C or higher and 100°C or lower.

For example, the temperature of the canister for the second precursor compound may be 10°C or higher and 100°C or lower, 20°C or higher and 100°C or lower, 30°C or higher and 100°C or lower, 40°C or higher and 100°C or lower, 50°C or higher and 100°C or lower, 60°C or higher and 100°C or lower, 70°C or higher and 100°C or lower, 10°C or higher and 90°C or lower, 10°C or higher and 80°C or lower, 10°C or higher and 70°C or lower, 10°C or higher and 60°C or lower, 10°C or higher and 50°C or lower, or 10°C or higher and 40°C or lower.

A canister is used to supply a source gas and a reaction gas into a reaction chamber in the thin film manufacturing method. Typically, the canister vaporizes a precursor compound to produce the source gas and the reaction gas, and then supplies the produced gases into the chamber.

When the temperature of the canister does not fall within the above numerical range, uniformity in the thickness of the thin film, manufactured by the thin film manufacturing method, may be significantly reduced.

This is because a uniform film is challenging to obtain due to an insufficient supply of the precursor compounds to the chamber below the minimum temperature range and due to deterioration caused by thermal energy or an excessive supply of the precursor compounds to the chamber above the maximum temperature range.

In one embodiment, the injection time of the first precursor compound may be 1 second or more and 30 seconds or less, and the injection time of the second precursor compound may be 1 second or more and 30 seconds or less. Preferably, the injection time of the first precursor compound is 1 second or more and 15 seconds or less, and the injection time of the second precursor compound is 1 second or more and 15 seconds or less.

For example, the injection time of the first precursor compound may be 1 second or more and 20 seconds or less, 1 second or more and 15 seconds or less, 2 seconds or more and 15 seconds or less, 3 seconds or more and 15 seconds or less, 4 seconds or more and 15 seconds or less, 5 seconds or more and 15 seconds or less, 2 seconds or more and 10 seconds or less, 3 seconds or more and 10 seconds or less, 4 seconds or more and 10 seconds or less, 5 seconds or more and 10 seconds or less, 1 second or more and 10 seconds or less, 1 second or more and 8 seconds or less, 1 second or more and 6 seconds or less, or 1 second or more and 5 seconds or less.

Additionally, the injection time of the second precursor compound may be 1 second or more and 20 seconds or less, 1 second or more and 15 seconds or less, 2 seconds or more and 15 seconds or less, 3 seconds or more and 15 seconds or less, 4 seconds or more and 15 seconds or less, 5 seconds or more and 15 seconds or less, 2 seconds or more and 10 seconds or less, 3 seconds or more and 10 seconds or less, 4 seconds or more and 10 seconds or less, 5 seconds or more and 10 seconds or less, 1 second or more and 10 seconds or less, 1 second or more and 8 seconds or less, 1 second or more and 6 seconds or less, or 1 second or more and 5 seconds or less.

When the process is performed while the injection time of the first precursor compound and the injection time of the second precursor compound exceed or fall below the above numerical ranges, it may be challenging to form an appropriate thin film.

Specifically, when the injection time of the first precursor compound falls below the above numerical range, the reactant necessary for thin film formation may be insufficient, so a thin film having an appropriate thickness may not be formed. On the other hand, when the injection time of the first precursor compound exceeds the above numerical range, the composition ratio of the thin film manufactured may be inconsistent due to impurities generated by the compound remaining after the reaction.

In addition, the injection time of the second precursor compound may vary depending on the type of the first precursor compound.

For example, when the first precursor compound is DIS, the injection time of the second precursor compound may be 1 second or more and 20 seconds or less, 2 seconds or more and 19 seconds or less, 3 seconds or more and 18 seconds or less, or 4 seconds or more and 17 seconds or less. Preferably, the injection time of the second precursor compound is 5 seconds or more and 15 seconds or less.

For example, when the first precursor compound is TCDS, the injection time of the second precursor compound may be 1 second or more and 15 seconds or less, 2 seconds or more and 15 seconds or less, 3 seconds or more and 15 seconds or less, or 4 seconds or more and 15 seconds or less. Preferably, the injection time of the second precursor compound is 5 seconds or more and 15 seconds or less, and more preferably 10 seconds.

For example, when the first precursor compound is DIPAS, the injection time of the second precursor compound may be 1 second or more and 15 seconds or less, 2 seconds or more and 15 seconds or less, 3 seconds or more and 15 seconds or less, or 4 seconds or more and 15 seconds or less. Preferably, the injection time of the second precursor compound is 2 seconds or more and 10 seconds or less, and more preferably 5 seconds.

When the injection time of the second precursor compound is less than 1 second, the residual amount of the first precursor compound, the reactant, may increase, leading to an inappropriate reaction. Additionally, the thin film layer may be deposited nonuniformly due to the generation of impurities. On the other hand, when the injection time of the second precursor compound exceeds 30 seconds, impurities may be generated by the second precursor compound.

In one embodiment, the injection time of the purge gas in the first purge step may be 1 second or more and 1 minute or less, and the injection time of the purge gas in the second purge step may be 1 second or more and 1 minute or less.

In one embodiment, the injection time of the first purge gas in the first purge step may be 1 second or more and 60 seconds or less, 1 second or more and 50 seconds or less, 1 second or more and 40 seconds or less, 1 second or more and 30 seconds or less, 1 second or more and 20 seconds or less, 1 second or more and 15 seconds or less, or 1 second or more and 10 seconds or less.

Additionally, the injection time of the purge gas in the second purge step may be 1 second or more and 60 seconds or less, 1 second or more and 50 seconds or less, 1 second or more and 40 seconds or less, 1 second or more and 30 seconds or less, 1 second or more and 20 seconds or less, 1 second or more and 15 seconds or less, or 1 second or more and 10 seconds or less.

When the injection time of the first or second purge gas falls below the above numerical range, the residual amount of the first or second precursor compound may increase, leading to an inappropriate reaction. Additionally, the thin film layer may be deposited nonuniformly because impurities are not purged.

In one embodiment, the thin film may be in an amorphous state, a mixed state of amorphous and nanocrystalline states, or a nanocrystalline state.

In general, in ALD, atoms or molecules are arranged in a disordered manner without a regular pattern. This typically occurs during a rapid cooling process or particular chemical process and occurs when there is not enough time for the formation of crystal structures.

Thin films in an amorphous state may be produced by ALD processes, and materials in such a state typically exhibit isotropic thermal, mechanical, and electrical properties.

A nanocrystalline state refers to a material having a nanometer-scale crystalline structure. Nanocrystals have unique physical properties due to having small size and high surface-to-volume ratio. Materials in such a state may exhibit different properties from those of materials in an amorphous state in terms of electrical, optical, and mechanical properties. Thin films in a nanocrystalline state may be manufactured through ALD processes.

In thin film deposition processes, the morphology of a thin film may be determined during deposition under specific conditions of temperature, pressure, and deposition time, or may be determined through a crystallization process after deposition of the thin film.

In the present application, the surface morphology of the thin film may be controlled by the types of the first precursor compound and the second precursor compound.

In addition, according to the manufacturing method of the present application, a thin film in a nanocrystalline state or a mixed state of amorphous and nanocrystalline states can be obtained without separately performing additional heat treatment after deposition.

In one embodiment, the thin film manufactured by the manufacturing method may be a pure silicon (Si) thin film. However, carbon (C) or oxygen (O) may be detected from the thin film due to oxidation or contamination of the surface of the thin film.

In one embodiment, the thin film manufactured by the manufacturing method may have a grain size of 30 nm or greater and 50 nm or smaller, as measured with an SEM.

For example, the grain size may be 30 nm or greater and 50 nm or smaller, 30.5 nm or greater and 49 nm or smaller, 31 nm or greater and 48 nm or smaller, 31 nm or greater and 46 nm or smaller, 31.7 nm or greater and 45.2 nm or smaller, or 37.3 nm or greater and 47.6 nm or smaller.

In one embodiment, the thin film manufactured by the manufacturing method may have a roughness (Rq) value of 0.1 nm or greater and 0.5 nm or smaller, as measured with an AFM at a scan size of 5 μm.

For example, the Rq value may be 0.1 nm or greater and 0.5 nm or smaller, 0.15 nm or greater and 0.4 nm or smaller, 0.15 nm or greater and 0.3 nm or smaller, 0.2 nm or greater and 0.25 nm or smaller, 0.2 nm or greater and 0.3 nm or smaller, 0.2 nm or greater and 0.35 nm or smaller, 0.2 nm or greater and 0.4 nm or smaller, 0.21 nm or greater and 0.39 nm or smaller, 0.22 nm or greater and 0.36 nm or smaller, 0.3 nm or greater and 0.5 nm or smaller, 0.31 nm or greater and 0.49 nm or smaller, 0.32 nm or greater and 0.48 nm or smaller, 0.33 nm or greater and 0.46 nm or smaller, or 0.34 nm or greater and 0.45 nm or smaller.

In one embodiment, the thin film manufactured by the manufacturing method may have a roughness (Ra) value of 0.1 nm or greater and 0.4 nm or smaller, as measured with an AFM at a scan size of 5 μm.

For example, the Ra value may be 0.1 nm or greater and 0.4 nm or smaller, 0.12 nm or greater and 0.35 nm or smaller, 0.14 nm or greater and 0.3 nm or smaller, 0.15 nm or greater and 0.29 nm or smaller, 0.17 nm or greater and 0.28 nm or smaller, 0.17 nm or greater and 0.3 nm or smaller, 0.17 nm or greater and 0.35 nm or smaller, 0.17 nm or greater and 0.4 nm or smaller, 0.2 nm or greater and 0.4 nm or smaller, 0.21 nm or greater and 0.39 nm or smaller, 0.22 nm or greater and 0.38 nm or smaller, 0.23 nm or greater and 0.36 nm or smaller, or 0.24 nm or greater and 0.35 nm or smaller.

## Mode for Invention

Hereinafter, the present application will be described in more detail using the following preparation examples. However, the present application is not limited thereto.

### [Preparation Example]

A thin film was manufactured using the first precursor compound and the second precursor compound described above with ALD equipment.

A substrate used in this experiment was a p-type Si(100) wafer with a resistivity of 0.02 Ω·cm. Before deposition, the p-type Si wafer was sonicated in acetone, ethanol, and deionized water (DIW) for 10 minutes each and cleaned. The native oxide thin film on the Si wafer was immersed in a 10% HF solution (HF:$H_2O$ = 1:9) for 10 seconds and then removed. The HF-cleaned Si wafer was immediately transferred to an ALD chamber.

In addition, as shown in Table 1 below, the first precursor compound and the second precursor compound used in the manufacturing of the thin film are any one of diiodosilane (DIS), tetrachlorodisilane (TCDS), and diisopropylaminosilane (DIPAS).

The temperature of a canister for the first precursor compound was maintained at 25°C in Preparation Example 1 and maintained at room temperature (ranging from 21°C to 23°C) in Preparation Examples 2 and 3.

The first precursor compound, argon (Ar), the second precursor compound, and argon (Ar) were supplied in sequence to constitute one cycle.

The injection time of the first precursor compound (DIS) was adjusted to 3 to 10 seconds in Preparation Example 1, the injection time of the first precursor compound (TCDS) was adjusted to 2 to 10 seconds in Preparation Example 2, and the injection time of the first precursor compound (DIPAS) was adjusted to 1 to 10 seconds in Preparation Example 3.

In this case, the injection amount of the first precursor compound was set to 200 sccm for DIS in Preparation Example 1, to 200 sccm for TCDS in Preparation Example 2, and to 100 sccm for DIPAS in Preparation Example 3. Additionally, the process pressure was set to be in the range of 3.2 to 4.0 Torr.

When it comes to the second precursor compound used in Preparation Examples 1 to 3, the injection time was adjusted to 5 to 15 seconds for DIPAS in Preparation Example 1, to 1 to 10 seconds for DIPAS in Preparation Example 2, and to 2 to 10 seconds for TCDS in Preparation Example 3. Additionally, the injection amount was set to 100 sccm in Preparation Examples 1 and 2 and to 200 sccm in Preparation Example 3 by controlling the on/off operation of a pneumatic valve.

The injection amount of argon (Ar) for purging the second precursor compound was set to 100 sccm.

The process temperature was in the range of 400°C to 500°C in Preparation Example 1 and in the range of 400°C to 450°C in Preparation Examples 2 and 3. Additionally, the reactor pressure was set to be in the range of 3.0 to 4.0 torr, and the number of cycles was set to 180 in Preparation Example 1 and to 200 in Preparation Examples 2 and 3.

Table 1 below shows the process conditions for manufacturing a thin film according to each preparation example.

[Table 1]

| | First precursor | Second precursor | First precu injection t (s) | First time (s) | Second precursor injection (s) | second purge t(s) | Process temperature | Cycle ((number) |
|---|---|---|---|---|---|---|---|---|
| Preparation Example 1 | DIS | DIPAS | 3 to 10 | 10 | 5 to 15 | 10 | 400 to 500 | 180 |
| Preparation Example 2 | TCDS | DIPAS | 2 to 10 | 10 | 1 to 10 | 10 | 400 to 450 | 200 |
| Preparation Example 3 | DIPAS | TCDS | 1 to 10 | 10 | 2 to 10 | 10 | 400 to 450 | 200 |

In Table 1, DIS refers to diiodosilane, TCDS refers to tetrachlorodisilane, and DIPAS refers to diisopropylaminosilane.

[Evaluation Example 1 - Changes in Thin Film Deposition Rate according to First Precursor Compound Injection Time]

Under the process conditions described in Table 1, thin films were manufactured according to the preparation examples above by varying the injection time of the first precursor compound to a range of 3 to 10 seconds for Preparation Example 1 and to a range of 2 to 10 seconds for Preparation Example 2. Then, the deposition rate (GPC) of the thin films was measured. The deposition rate for Preparation Example 1 is shown in FIG. 1(a), and the deposition rate for Preparation Example 2 is shown in FIG. 1(b).

Hereinafter, the deposition rate in Evaluation Examples 1 to 3 was calculated using the following Equation 1.

[Equation 1]

$$\text{Deposition rate (Å/cycle)} = \text{deposition thickness/number of ALD cycles}$$

The deposition thickness in Equation 1 was measured with an ellipsometer and confirmed with a field emission scanning electron microscope (FE-SEM).

At a process temperature of 480°C, ALD processes were performed according to the respective manufacturing methods in Preparation Examples 1 and 2. During this process, the self-limiting reaction was confirmed by measuring the injection time of the first precursor (source feeding time) exhibiting a constant thin film deposition rate.

As shown in FIG. 1(a), a constant thin film deposition rate is observed when the injection time of the first precursor compound (DIS) in Preparation Example 1 is in the range of 5 to 10 seconds.

Additionally, as shown in FIG. 1(b), a constant thin film deposition rate is observed when the injection time of the first precursor compound (TCDS) in Preparation Example 2 is in the range of 5 to 10 seconds.

[Evaluation Example 2 - Changes in Thin Film Deposition Rate according to Second Precursor Compound Injection Time]

Under the process conditions described in Table 1, a thin film was manufactured according to the preparation example above by varying the injection time of the second precursor compound to a range of 5 to 15 seconds for Preparation Example 1. Then, the deposition rate of the thin film was measured. The deposition rate for Preparation Example 1 is shown in FIG. 2.

At a process temperature of 480°C, an ALD process was performed according to the manufacturing method in Preparation Example 1 using the first precursor compound and the second precursor compound in Preparation Example 1 as the source and reaction gas (reactant), respectively. During this process, the self-limiting reaction was confirmed by measuring the injection time of the second precursor exhibiting a constant thin film deposition rate.

As shown in FIG. 2, a constant thin film deposition rate is observed when the injection time of the second precursor compound (DIPAS) in Preparation Example 1 is in the range of 10 to 15 seconds.

In the meantime, under the process conditions described in Table 1, a thin film was manufactured according to the preparation example above by varying the injection time of the second precursor to a range of 1 to 10 seconds for Preparation Example 2. Then, the deposition rate of the thin film was measured.

At a process temperature of 410°C, an ALD process was performed according to the manufacturing method in Preparation Example 2 using the first precursor compound and the second precursor compound in Preparation Example 2 as the source and reaction gas (reactant), respectively. During this process, the self-limiting reaction was confirmed by measuring the injection time of the second precursor exhibiting a constant thin film deposition rate.

As a result of the measurement, a constant thin film deposition rate of 0.2 Å/cycle was observed when the injection time of the second precursor compound (DIPAS) in Preparation Example 2 was in the range of 5 to 10 seconds.

**[Evaluation Example 3 - Changes in Thin Film Deposition Rate according to Process Temperatures]**

Under the process conditions described in Table 1, thin films were manufactured according to the preparation examples above by varying the process temperature to a range of 400°C to 500°C for Preparation Example 1 and to a range of 400°C to 450°C for Preparation Example 2. Then, the deposition rate of the thin films was measured. The deposition rate for Preparation Example 1 is shown in FIG. 3(a), and the deposition rate for Preparation Example 2 is shown in FIG. 3(b).

As shown in FIG. 3(a), when the first precursor compound (DIS) in Preparation Example 1 was used as the source and the second precursor compound (DIPAS) used was injected as the reaction gas (reactant), a constant deposition rate was confirmed at a process temperature in the range of 400°C to 480°C.

As shown in FIG. 3(b), when the first precursor compound (TCDS) in Preparation Example 2 was used as the source and the second precursor compound (DIPAS) used was injected as the reaction gas (reactant), a constant deposition rate was confirmed at a process temperature in the range of 400°C to 420°C.

In other words, the temperature of the ALD window was in the range of 400°C to 480°C for Preparation Example 1, and the temperature of the ALD window was in the range of 400°C to 420°C for Preparation Example 2.

**[Evaluation Example 4 - Grain Size Analysis of Preparation Example 1]**

SEM analysis was performed to examine the grain size in the case of Preparation Example 1 using DIS as the first precursor compound and DIPAS as the second precursor compound.

FIG. 4(a) shows an SEM image of a thin film manufactured according to Preparation Example 1 at a process temperature of 400°C, and FIG. 4(b) shows an SEM image of a thin film manufactured according to Preparation Example 1 at a process temperature of 480°C.

As shown in FIG. 4(a), the SEM analysis result for the surface of the thin film manufactured by ALD using DIS as the first precursor compound and DIPAS as the second precursor compound at 400°C showed that the grain size of 10 randomly selected grains within a sample having an area of 2 cm $\times$ 2 cm was 9.5 nm on average (ranging from 5.5 nm to 11.9 nm).

As shown in FIG. 4(b), the SEM analysis result for the surface of the thin film manufactured by ALD using DIS as the first precursor compound and DIPAS as the second precursor compound at 480°C showed that the grain size of 10 randomly selected grains within a sample having an area of 2 cm $\times$ 2 cm was 38.9 nm on average (ranging from 31.7 nm to 45.2 nm).

In other words, when DIS and DIPAS were used as the first precursor and the second precursor compound, respectively, in Preparation Example 1, it was confirmed that an amorphous thin film was formed as the process temperature decreased, whereas a nanocrystalline thin film was formed as the process temperature increased.

In the meantime, as examined in Evaluation Example 6 below, it was confirmed that even in the case of Preparation Example 2, an amorphous thin film was formed in which no diffraction peaks due to crystals were observed as a result of XRD analysis.

**[Evaluation Example 5 - AFM Analysis Results of Preparation Examples 2 and 3]**

AFM analysis was performed to examine the morphology of the thin film manufactured according to Preparation Example 2 using TCDS as the first precursor compound and DIPAS as the second precursor compound, and the thin film manufactured according to Preparation Example 3 using DIPAS as the first precursor compound and TCDS as the second precursor compound.

FIG. 5(a) shows AFM images of the thin film manufactured according to Preparation Example 2 at a process temperature of 410°C, and FIG. 5(b) AFM images of the thin film manufactured according to Preparation Example 2 at a process temperature of 450°C.

As shown in FIG. 5(a), the AFM analysis results for the surface of the thin film manufactured by ALD using TCDS as the first precursor compound and DIPAS as the second precursor compound at 410°C are as shown in Table 2 below.

[Table 2]

| Scan size ( | Rq ( | Ra ( |
|---|---|---|
| 1 × 1 | 0.38 | 0.29 |
| 5 × 5 | 0.35 | 0.27 |
| 10 × 10 | 0.31 | 0.25 |

In Table 2 above, Rq represents an average squared peak height, and Ra represents an average two-dimensional surface roughness.

As shown in FIG. 5(b), the AFM analysis results for the surface of the thin film manufactured by ALD using TCDS as the first precursor compound and DIPAS as the second precursor compound at 450°C are as shown in Table 3 below.

[Table 3]

| Scan size ( | Rq ( | Ra ( |
|---|---|---|
| 1 × 1 | 0.44 | 0.34 |
| 5 × 5 | 0.37 | 0.29 |
| 10 × 10 | 0.33 | 0.26 |

In Table 3 above, Rq represents an average squared peak height, and Ra represents an average two-dimensional surface roughness.

In the meantime, the AFM analysis results for the surface of the thin film manufactured according to Preparation Example 3 by ALD using DIPAS as the first precursor compound and TCDS as the second precursor compound at a process temperature of 410°C are as shown in Table 4 below.

[Table 4]

| Scan size ( | Rq ( | Ra ( |
|---|---|---|
| 2×2 | 0.26 | 0.20 |
| 5×5 | 0.22 | 0.17 |
| 10 × 10 | 0.18 | 0.14 |

In Table 4 above, Rq represents an average squared peak height, and Ra represents an average two-dimensional surface roughness.

In other words, when TCDS and DIPAS were used as the first precursor compound and the second precursor compound, respectively, in Preparation Example 2, it was confirmed that the Rq and Ra values of the manufactured thin film decreased as the process temperature decreased, whereas the Rq and Ra values of the manufactured thin film increased as the process temperature increased.

In the meantime, the surface roughness of the thin films of Preparation Examples 2 and 3, manufactured by changing the injection order of the precursor compounds, was confirmed using an SEM.

FIG. 6(a) shows SEM images of the thin film manufactured according to Preparation Example 2 at a process temperature of 410°C, and FIG. 6(b) shows SEM images of the thin film manufactured according to Preparation Example 3 at a process temperature of 410°C, manufactured by changing the injection order of the precursor compounds from Preparation Example 2.

In other words, as shown in FIGS. 6(a) and 6(b) and in Tables 2 and 4, it was confirmed that, among the surface of the thin film (FIG. 6(a)) manufactured according to Preparation Example 2 by ALD using TCDS as the first precursor compound and DIPAS as the second precursor compound, and the surface of the thin film (FIG. 6(b)) manufactured according to Preparation Example 3 by ALD using DIPAS as the first precursor compound and TCDS as the second precursor compound, at a process temperature of 410°C, the surface roughness of the thin film (FIG. 6(b)) manufactured according to Preparation Example 3 by injecting DIPAS first was improved.

**[Evaluation Example 6 - XRD Result of Preparation Example 2]**

XRD analysis was performed to examine the morphology of the thin film manufactured according to Preparation Example 2 using TCDS as the first precursor compound and DIPAS as the second precursor compound.

FIG. 7(a) is a graph showing the XRD analysis result of the thin film manufactured according to Preparation Example 2 at a process temperature of 410°C.

FIG. 7(b) is a graph showing the XRD analysis result of the thin film manufactured according to Preparation Example 2 at a process temperature of 450°C.

As shown in FIGS. 7(a) and 7(b), the XRD analysis result for the thin film manufactured according to Preparation Example 2 by ALD using TCDS as the first precursor compound and DIPAS as the second precursor compound showed that no diffraction peak with strong intensity was observed.

In other words, it was confirmed that an amorphous silicon thin film was formed according to Preparation Example 2 of the present application.

Through the thin film manufacturing described above, it was confirmed that, according to the manufacturing method using the first precursor compound and the second precursor compound in Preparation Examples 1 to 3, a silicon thin film having excellent properties was formed by ALD even during a low-temperature process at 500°C or lower.

The scope of the present application is defined by the appended claims rather than the detailed description presented above. All changes or modifications derived from the meaning and scope of the claims and the concept of equivalents should be construed to fall within the scope of the present application.

**Industrial Applicability**

A thin film manufacturing method of the present application can efficiently manufacture a silicon thin film having excellent properties.

Specifically, in the present application, a low-temperature ALD process is possible even at temperatures of 500°C or lower by introducing two types of silicon precursor compounds. In this case, these precursor compounds serve as a source and a reactant, and a thin film that is amorphous or nanocrystalline, depending on the types of precursor compounds, can be deposited.

In particular, by depositing an amorphous silicon thin film, a polycrystalline silicon thin film having a large grain boundary size can be manufactured during crystallization.

In other words, the thin film manufacturing method of the present application enables uniform deposition of a thin film having excellent properties even at low temperatures using two types of silicon precursor compounds. This allows the thin film obtained as above to secure excellent physical properties, thickness, and step coverage, and enables control of the morphology and crystallinity of the deposited thin film.

Furthermore, the thin film having excellent properties, manufactured by the thin film manufacturing method of the present disclosure, can be used in dielectrics, displays, next-generation memories, non-memory semiconductors, and the like of various electronic devices.

**Claims**

1. A thin film manufacturing method of depositing a thin film by repeatedly performing a cycle comprising:

   performing a first injection by injecting a first precursor compound into a chamber; and
   performing a second injection by injecting a second precursor compound into the chamber,
   wherein the first precursor compound is represented by Chemical Formula 1 or 2 below, and
   the second precursor compound is represented by Chemical Formula 1 or 2 below
   (wherein when the first precursor compound is a compound represented by Chemical Formula 1 below, the second precursor compound is a compound represented by Chemical Formula 2 below, and
   when the first precursor compound is a compound represented by Chemical Formula 2 below, the second precursor compound is a compound represented by Chemical Formula 1 below),

   [Chemical Formula 1] $\quad$ $Si_x(R_1)_yH_{(2x+2-y)}$

   [Chemical Formula 2] $\quad$ $Si(NR_2R_3)_zH_{(4-z)}$

   wherein in Chemical Formulas 1 and 2,
   $R_1$ is any one selected from the group consisting of fluorine (F), chlorine (Cl), bromine (Br), and iodine (I),
   $R_2$ and $R_3$ are each independently any one selected from the group consisting of straight-chain or branched-chain hydrocarbons having 1 to 4 carbon atoms,
   x is an integer in a range of 1 to 3,

y is an integer in a range of 1 to 7, and
z is an integer in a range of 1 to 3.

2. The thin film manufacturing method of claim 1, wherein $R_1$ in Chemical Formula 1 is chlorine (Cl) or iodine (I),

x is 1 or 2, and
y is 2 or 4.

3. The thin film manufacturing method of claim 1, wherein $R_2$ and $R_3$ in Chemical Formula 2 are each independently any one selected from the group consisting of a methyl group, an ethyl group, an n-propyl group, an isopropyl group, an n-butyl group, an isobutyl group, a sec-butyl group, and a tert-butyl group, and
z is 1 or 2.

4. The thin film manufacturing method of claim 1, wherein the cycle further comprises:

performing a first purge by injecting a first purge gas into the chamber, between the first injection and the second injection; and
performing a second purge by injecting a second purge gas into the chamber, after the second injection.

5. The thin film manufacturing method of claim 1, wherein the compound represented by Chemical Formula 1 is any one selected from the group consisting of fluorosilane, chlorosilane, bromosilane, iodosilane, difluorosilane, dichlorosilane, dibromosilane, diiodosilane, trifluorosilane, trichlorosilane, tribromosilane, triiodosilane, tetrafluorosilane, tetrachlorosilane, tetrabromosilane, tetraiodosilane, fluorodisilane, chlorodisilane, bromodisilane, iododisilane, difluorodisilane, dichlorodisilane, dibromodisilane, diiododisilane, trifluorodisilane, trichlorodisilane, tribromodisilane, triiododisilane, tetrafluorodisilane, tetrachlorodisilane, tetrabromodisilane, and tetraiododisilane.

6. The thin film manufacturing method of claim 1, wherein the compound represented by Chemical Formula 2 is any one selected from the group consisting of dimethylaminosilane, diethylaminosilane, diisopropylaminosilane, dibutylaminosilane, diisobutylaminosilane, di-sec-butylaminosilane, dimethylethylsilane diamine, di-tert-butylaminosilane, dimethylpropylsilane diamine, and bis(diethylamino)silane.

7. The thin film manufacturing method of claim 1, wherein the thin film manufacturing method is performed at a process temperature of 350°C or higher and 500°C or lower.

8. The thin film manufacturing method of claim 1, wherein the thin film is in an amorphous state, a mixed state of amorphous and nanocrystalline states, or a nanocrystalline state.

Figure 1

Figure 2

Figure 3

(a)

(b)

Figure 4

(a)

<1μm x 1μm>          <5μm x 5μm>          <10μm x 10μm>

(b)

<1μm x 1μm>          <5μm x 5μm>          <10μm x 10μm>

Figure 5

Figure 6

Figure 7

## INTERNATIONAL SEARCH REPORT

| International application No. |
|---|
| **PCT/KR2024/010330** |

| A. | CLASSIFICATION OF SUBJECT MATTER |
|---|---|

**C23C 16/455**(2006.01)i; **C23C 16/44**(2006.01)i; **C23C 16/34**(2006.01)i; **C23C 16/40**(2006.01)i; **H01L 21/02**(2006.01)i

According to International Patent Classification (IPC) or to both national classification and IPC

| B. | FIELDS SEARCHED |
|---|---|

Minimum documentation searched (classification system followed by classification symbols)

C23C 16/455(2006.01); C07C 211/44(2006.01); C07C 239/02(2006.01); C23C 16/44(2006.01); C23C 16/52(2006.01); H01L 21/316(2006.01); H01L 21/324(2006.01); H01L 21/768(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 원자층 증착(atomic layer deposition), 실리콘(Si), 박막(thin film), 디아이오도실란 (DIS), 테트로클로로 다이실란(TCDS), 디이소프로필아미노실란(DIPAS)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | KR 10-2020-0055630 A (JUSUNG ENGINEERING CO., LTD.) 21 May 2020 (2020-05-21) See paragraphs [0002]-[0003], [0029], [0034], [0040] and [0068] and claims 2-5 and 8. | 1-8 |
| X | KR 10-1569377 B1 (TOKYO ELECTRON LIMITED) 16 November 2015 (2015-11-16) See claims 2-3, 7 and 9. | 1-8 |
| X | KR 10-2022-0003470 A (ASM IP HOLDING B.V.) 10 January 2022 (2022-01-10) See paragraphs [0050]-[0055] and claims 1-5. | 1-8 |
| A | US 2023-0089397 A1 (ASM IP HOLDING B.V.) 23 March 2023 (2023-03-23) See paragraphs [0018] and [0085]-[0086] and claim 17. | 1-8 |
| A | KR 10-2015-0108664 A (EUGENE TECHNOLOGY MATERIALS et al.) 30 September 2015 (2015-09-30) See paragraphs [0091]-[0094] and claims 1-10. | 1-8 |

☐ Further documents are listed in the continuation of Box C.　　☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **24 October 2024** | **24 October 2024** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

# EP 4 748 968 A1

International application No.

**PCT/KR2024/010330**

| Patent document cited in search report | | | Publication date (day/month/year) | Patent family member(s) | | | Publication date (day/month/year) |
|---|---|---|---|---|---|---|---|
| KR | 10-2020-0055630 | A | 21 May 2020 | KR | 10-2024-0083135 | A | 11 June 2024 |
| | | | | KR | 10-2671466 | B1 | 03 June 2024 |
| KR | 10-1569377 | B1 | 16 November 2015 | CN | 103094077 | A | 08 May 2013 |
| | | | | CN | 103094077 | B | 07 September 2016 |
| | | | | JP | 2013-110385 | A | 06 June 2013 |
| | | | | JP | 5829196 | B2 | 09 December 2015 |
| | | | | KR | 10-2013-0047594 | A | 08 May 2013 |
| | | | | TW | 201333248 | A | 16 August 2013 |
| | | | | TW | I521086 | B | 11 February 2016 |
| | | | | US | 2013-0109197 | A1 | 02 May 2013 |
| KR | 10-2022-0003470 | A | 10 January 2022 | CN | 113881930 | A | 04 January 2022 |
| | | | | TW | 202204689 | A | 01 February 2022 |
| | | | | US | 2022-005693 | A1 | 06 January 2022 |
| US | 2023-0089397 | A1 | 23 March 2023 | CN | 115807217 | A | 17 March 2023 |
| | | | | KR | 10-2023-0040902 | A | 23 March 2023 |
| | | | | TW | 202336258 | A | 16 September 2023 |
| KR | 10-2015-0108664 | A | 30 September 2015 | TW | 201542574 | A | 16 November 2015 |
| | | | | WO | 2015-141956 | A1 | 24 September 2015 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 20210024673

- KR 20150102725